Europäisches Patentamt

European Patent Office

Office européen des brevets

(19)

(11) EP 0 685 934 B1

(12) FASCICULE DE BREVET EUROPEEN

(45) Date de publication et mention de la délivrance du brevet:
**09.09.1998 Bulletin 1998/37**

(51) Int Cl.⁶: **H03G 3/20**

(21) Numéro de dépôt: **95401112.8**

(22) Date de dépôt: **12.05.1995**

(54) **Dispositif de régulation sans pointe ni étouffement du niveau de signal en sortie d'une chaîne d'amplification d'un émetteur**

Vorrichtung zum Regeln ohne Spitzen oder vollständiger Unterdrückung des Ausgangspegels einer Verstärkungskette in einen Sender

Control device having no peaks in nor extinctions of the output level of a chain of amplification in a transmitter

(84) Etats contractants désignés:
**DE FR GB IT**

(30) Priorité: **31.05.1994 FR 9406600**

(43) Date de publication de la demande:
**06.12.1995 Bulletin 1995/49**

(73) Titulaire: **THOMSON-CSF**
**75008 Paris (FR)**

(72) Inventeur: **Bouchet, André**
**F-92402 Courbevoie Cedex (FR)**

(74) Mandataire: **Lincot, Georges et al**
**Thomson-CSF Propriété Intellectuelle,**
**13, Avenue du Président Salvador Allende**
**94117 Arcueil Cédex (FR)**

(56) Documents cités:
EP-A- 0 632 585          US-A- 4 574 248
US-A- 5 138 274          US-A- 5 144 258

## Description

La présente invention telle qu'elle est définie dans les revendications concerne un dispositif de régulation sans pointe ni étouffement du niveau de signal en sortie d'une chaîne d'amplification d'un émetteur.

Pour éviter une distorsion par surmodulation du signal obtenu en sortie de l'étage de puissance d'un émetteur en fonction de l'amplitude plus ou moins importante du signal de modulation, il est connu d'adjoindre à la chaîne d'amplification de l'émetteur une boucle de commande de gain automatique, cette boucle étant généralement formée par un atténuateur variable du signal de modulation commandé en fonction du niveau du signal obtenu en sortie de la chaîne d'amplification.

Le document US-A-5 144 258 mentionne un amplificateur dont le gai est défini en fonction des signaux d'entrée et de sortie.

Avec un tel dispositif, le taux d'atténuation de l'atténuateur est minimum lorsqu'il n'y a pas de signal en sortie de la chaîne d'amplification et une application brutale d'un signal de modulation à l'entrée de la chaîne d'amplification entraîne, une surexcitation de l'étage de sortie de l'émetteur se traduisant par une surmodulation du fait que le temps de réponse de la boucle de commande de gain n'est pas instantané. D'autre part, comme il est toujours incorporé dans la boucle de commande de gain automatique une constante de temps de resensibilisation de l'émetteur pour assurer un bon fonctionnement en phonie, la tension qui apparaît aux bornes de la capacité d'intégration lors de l'application brutale de la modulation provoque ensuite un étouffement du niveau de signal en sortie de l'émetteur, pendant une durée assez importante correspondant au temps de décharge de la capacité d'intégration pour revenir à la valeur nominale de gain de la chaîne d'amplification.

Le but de l'invention est de pallier les inconvénients précités.

A cet effet, l'invention a pour objet un dispositif de régulation sans pointe ni étouffement du niveau de signal en sortie d'une chaîne d'amplification d'un émetteur comportant à son entrée un atténuateur variable commandé en fonction du niveau du signal en sortie de la chaîne d'amplification, caractérisé en ce qu'il comprend un circuit sommateur pour commander l'atténuation du circuit atténuateur, le circuit sommateur étant couplé par une première entrée, à la sortie de la chaîne d'amplification par l'intermédiaire d'un circuit de détection et par une deuxième entrée à la sortie d'un circuit de commande par l'intermédiaire d'un étage de mise en forme, et le circuit de commande étant commandé par le niveau du signal appliqué à l'entrée de l'atténuateur pour régler le gain de la chaîne d'amplification à sa valeur minimum en l'absence de signal d'entrée et libérer le gain progressivement dès que le signal d'entrée apparaît.

L'invention a pour principal avantage qu'elle permet de régler le gain de la chaîne d'amplification de l'émetteur à sa valeur minimum en absence de modulation et de contrôler la montée du signal HF dès que la modulation apparaît, en libérant progressivement le gain jusqu'à ce que la boucle de régulation de gain prenne le relais. Il n'y a de la sorte aucun retard qui est créé sur la transmission du signal HF. L'invention permet également de réduire le bruit dans la bande passante de l'émetteur en l'absence de modulation.

D'autres caractéristiques et avantages de l'invention apparaîtront à l'aide de la description qui suit faite en regard des dessins annexés qui représentent :

- la figure 1, un mode de réalisation d'un dispositif de régulation selon l'invention ;
- la figure 2, un mode de réalisation du circuit sommateur de la figure 1 ;
- la figure 3, un mode de réalisation du circuit de mise en forme de la figure 1 ;
- la figure 4, un mode de réalisation du circuit de commande de la figure 1.

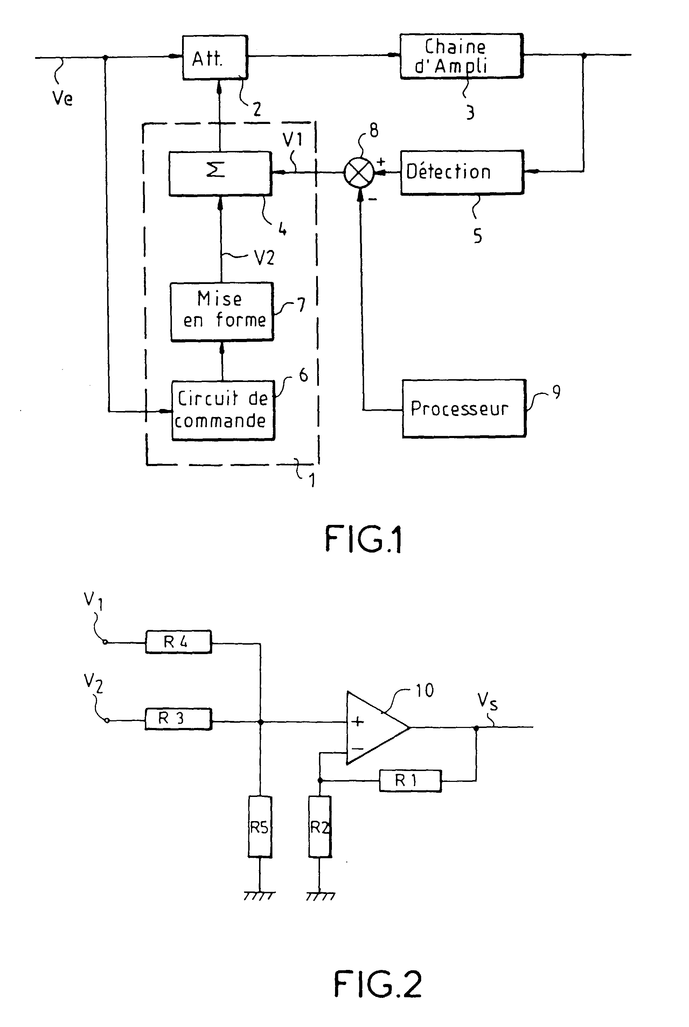

Le dispositif selon l'invention qui est représenté sur la figure 1 à l'intérieur d'une ligne fermée en pointillés 1 est couplé à l'entrée de commande du rapport d'atténuation d'un atténuateur variable 2 placé à l'entrée d'une chaîne d'amplification 3 d'un émetteur radio fréquence. Le dispositif 1 comprend un circuit sommateur 4 couplé d'une part, sur une première entrée à la sortie de la chaîne d'amplification 3 par l'intermédiaire d'un circuit de détection 5 et, d'autre part, sur une deuxième entrée à la sortie d'un circuit de commande 6 par l'intermédiaire d'un étage de mise en forme 7. Un circuit comparateur 8 possède deux entrées d'opérande reliées respectivement à la sortie du circuit de détection 5 et à une sortie de consigne de puissance du processeur 9. La sortie du circuit comparateur 8 applique une tension $V_1$ à une première entrée du circuit sommateur 4.

Le circuit sommateur 4 qui est représenté à la figure 2 se compose d'un amplificateur opérationnel différentiel 10 comportant, d'une part, un circuit de contreréaction formé par deux résistances $R_1$, $R_2$ interposé entre l'entrée notée (-) et la sortie de l'amplificateur 10 et, d'autre part, un circuit additionneur de tension à résistance formé par des résistances $R_3$, $R_4$ et $R_5$ montées en diviseur potentiométrique et placées à l'entrée notée (+) de l'amplificateur 10.

Suivant ce montage et en désignant par $V_s$ la tension de sortie de l'amplificateur 10 et par $V_1$ et $V_2$ les tensions appliquées aux extrémités respectives des résistances $R_4$ et $R_3$ la tension $V_s = f (V_1, V_2)$ est définie par la relation :

$$V_s = \frac{R_1 + R_2}{R_2} \times R_5 \times \left( \frac{1}{R_4} V_1 + \frac{1}{R_3} V2 \right)$$

En prenant à titre d'exemple les valeurs de résis-

tance suivantes : $R_1$ = 100 kΩ, $R_2$ = 1 kΩ, $R_3$ = 12 kΩ, $R_4$ = 100 kΩ et $R_5$ = 1 kΩ la tension $V_s$ devient $V_s$ = $V_1$ + $KV_2$ avec K = 8.

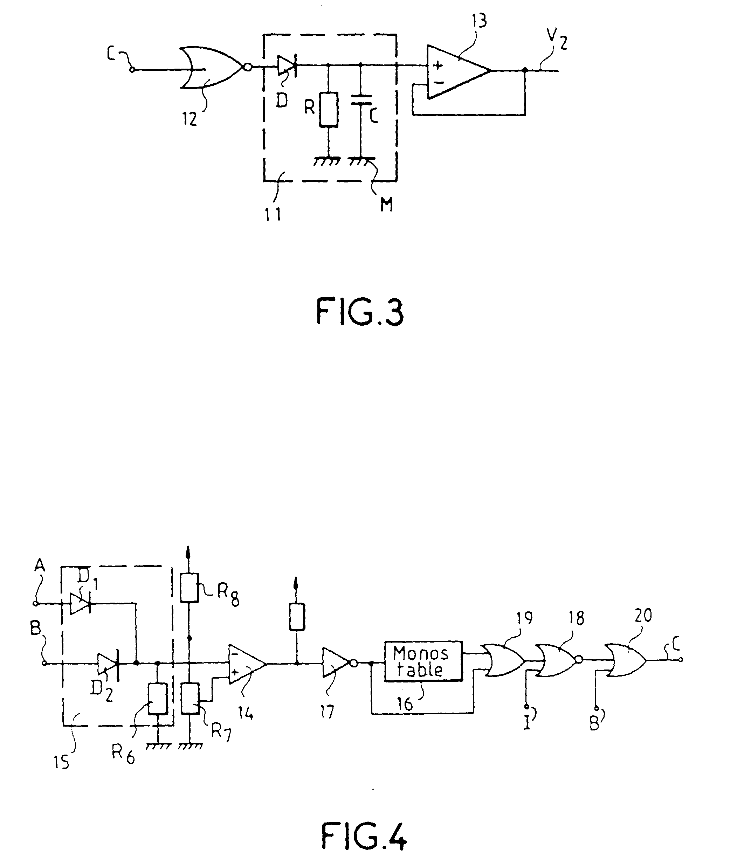

ce qui donne un gain qui est K fois plus fort pour la tension $V_2$ que pour la tension $V_1$. La tension $V_2$ est fournie par le circuit de mise en forme 7 qui comporte selon le mode de réalisation de la figure 3 un circuit de décharge de capacité 11, représenté à l'intérieur d'une ligne fermée en pointillés, couplé entre un étage inverseur 12 et un amplificateur opérationnel 13 à impédance d'entrée élevée et de gain unitaire. Le circuit 11 comporte une résistance R et un condensateur C montés en parallèle entre l'entrée notée (+) de l'amplificateur 13 et le circuit de masse M. Le circuit 11 comporte également une diode D reliée en série entre la sortie de l'étage inverseur 12 et l'entrée (+) de l'amplificateur 13. Les valeurs de R et C peuvent être par exemple fixées à R = 10 kΩ et C = 100 nF pour obtenir une constante de temps du circuit 11 de 1 ms. Avec une tension de commande de 5V appliquée à l'entrée de l'étage 12, ce circuit permet d'obtenir une tension $V_2$ qui suit la tension développée entre les deux extrémités du condensateur C. En supposant par exemple que la tension d'alimentation de l'amplificateur 10 de la figure 2 est de 12 Volts, la tension de sortie $V_s$ reste à 12 Volts tant que la tension entre les deux extrémités du condensateur C est supérieure à 1,5 Volt pour décroître par la suite en dessous de ce seuil.

Le circuit de commande 6 qui est représenté à la figure 4 comporte un circuit comparateur 14 interposé entre un circuit de détection 15 représenté à l'intérieur d'une ligne fermée en pointillés et un circuit monostable 16. Il comporte également un amplificateur inverseur 17 interposé entre la sortie du comparateur 14 et l'entrée du circuit monostable 16. Une porte "non ou" 18 est interposée entre deux portes "ou" 19 et 20 à la sortie du circuit monostable 16. Le circuit de détection 15 est formé d'une diode $D_1$ reliée par la cathode d'une part, à l'entrée (-) du comparateur 14 et, d'autre part, à une première extrémité d'une résistance $R_6$ dont l'autre extrémité est reliée au circuit de masse M.

L'entrée "+" du comparateur 14 est polarisée par la sortie d'un diviseur potentiométrique formé par un potentiomètre $R_7$ et une résistance $R_8$ reliés en série.

L'anode de la diode $D_1$ reçoit le signal basse fréquence appliqué à l'entrée de l'atténuateur 2 de la figure 2. En mode de transmission en bande latérale unique (BLU) le circuit 15 est complété par une deuxième diode $D_2$ jouant le même rôle que la diode $D_1$ pour la deuxième voie du circuit de démodulation qui peut être formé éventuellement par une boucle de Costas. Ce circuit permet d'obtenir un niveau de tension de 5 volts à la sortie C de la porte 20 lorsqu'aucune tension basse fréquence est appliquée à l'entrée du circuit de détection 15.

En présence d'une tension basse fréquence B à l'entrée du circuit de détection 15 le niveau de la sortie de la porte "Ou" 20 passe à l'état 0 volt.

Lorsque la tension basse fréquence est modulée, le circuit monostable 16 empêche le retour de la tension de sortie à 5 volt dans les blancs de modulation durant un intervalle de temps de 1 ms par exemple. Le potentiomètre $R_7$ permet d'effectuer un réglage du niveau de tension détecté. Le circuit non "ou" 18 comporte une entrée d'inhibition I pour supprimer l'action du circuit monostable 16 pour certains modes de modulation tels que par exemple les modes $A_1$, $A_3$, $F_1$.

Comme dans le mode $A_1$ il existe déjà une mise en forme lente avec un temps de montée de l'ordre de 7 ms du signal basse fréquence, le système composé des circuits 14, 15, 16 et 17 n'est de ce fait plus nécessaire.

Dans le mode $A_3$, comme il n'y a que la porteuse pure sans modulation basse fréquence, il faut aussi éviter que cette absence de modulation vienne empêcher l'émission de la HF.

Il en est de même dans le mode $F_1$.

Une tension de blocage est également appliquée sur une entrée du circuit "Ou" 20 pour tenir compte des retards qui sont apportés par certains équipements comme les relais d'alternat et la manipulation.

## Revendications

1. Dispositif de régulation (1) sans pointe ni étouffement du niveau de signal en sortie d'une chaîne d'amplification (3) d'un émetteur comportant à son entrée un atténuateur variable (2) commandé en fonction du niveau du signal en sortie de la chaîne d'amplification (3), caractérisé en ce qu'il comprend un circuit sommateur (4) pour commander l'atténuation du circuit atténuateur (2), le circuit sommateur (4) étant couplé par une première entrée, à la sortie de la chaîne d'amplification (3) par l'intermédiaire d'un circuit de détection (5) et par une deuxième entrée à la sortie d'un circuit de commande (6) par l'intermédiaire d'un étage de mise en forme (7), le circuit de commande (6) étant commandé par le niveau du signal appliqué à l'entrée de l'atténuateur (2) pour régler le gain de la chaîne d'amplification à sa valeur minimum en l'absence de signal d'entrée et libérer le gain progressivement dès que le signal d'entrée apparaît.

2. Dispositif selon la revendication 1, caractérisé en ce que le circuit sommateur (4) fournit une tension de commande de l'atténuateur (2) qui est la somme pondérée des tensions fournies par le circuit de détection (5) et le circuit de mise en forme (7), la pondération appliquée sur la tension fournie par le circuit de mise en forme (7) étant K fois supérieure à celle fournie par le circuit de détection (5).

3. Dispositif selon la revendication 2, caractérisé en ce que le circuit de mise en forme (7) comprend un circuit de décharge de capacité (11) pour contrôler la montée du signal basse fréquence atténué par l'atténuateur (2).

4. Dispositif selon la revendication 3, caractérisé en ce que le circuit de commande (6) comprend un circuit comparateur (14), couplé à un circuit monostable (16) pour fournir au circuit de mise en forme (7) un signal de commande lorsque le signal appliqué à l'entrée de l'atténuateur (2) dépasse une valeur de seuil prédéterminée.

## Patentansprüche

1. Vorrichtung zur Regelung des Signalpegels am Ausgang einer Verstärkungskette (3) eines Senders ohne Spitzen oder Signalauslöschung, mit einem variablen Dämpfungsglied (2) am Eingang, das abhängig vom Pegel des Ausgangssignals der Verstärkungskette (3) gesteuert wird, dadurch gekennzeichnet, daß die Vorrichtung eine Summierschaltung (4) zur Steuerung des Dämpfungsglieds (2) enthält, wobei ein erster Eingang der Summierschaltung (4) über eine Detektorschaltung (5) an den Ausgang der Verstärkungskette (3) und ein zweiter Eingang der Summierschaltung über eine Signalformungsstufe (7) an den Ausgang einer Steuerschaltung angeschlossen ist, die vom an den Eingang des Dämpfungsglieds (2) angelegten Signalpegel gesteuert wird, um den Verstärkungsgrad der Verstärkungskette auf seinen Mindestwert zu regeln, wenn kein Eingangssignal vorliegt, und den Verstärkungsgrad progressiv freizugeben, sobald das Eingangssignal auftritt.

2. Vorrichtung nach Anspruch 1, dadurch gekennzeichnet, daß die Summierschaltung (4) eine Steuerspannung für das Dämpfungsglied (2) liefert, die die gewichtete Summe der Spannungen ist, die von der Detektorschaltung (5) bzw. der Signalformungsstufe (7) geliefert werden, wobei die Gewichtung, die auf die von der Signalformungsstufe (7) gelieferte Spannung angewandt wird, K mal größer ist als diejenige der von der Detektorschaltung (5) gelieferten Spannung.

3. Vorrichtung nach Anspruch 2, dadurch gekennzeichnet, daß die Signalformungsstufe (7) eine Schaltung (11) zur Entladung eines Kondensators (11) enthält, um den Anstieg des Niederfrequenzsignals zu kontrollieren, das vom Dämpfungsglied (2) gedämpft wird.

4. Vorrichtung nach Anspruch 3, dadurch gekennzeichnet, daß die Steuerschaltung (6) eine Komparatorschaltung (14) enthält, die an eine monostabile Kippstufe (16) gekoppelt ist, sodaß der Signalformungsstufe (7) ein Steuersignal geliefert wird, wenn das an den Eingang des Dämpfungsglieds (2) angelegte Signal einen vorbestimmten Schwellenwert übersteigt.

## Claims

1. Control device (1) having no peaks in nor extinctions of the output signal level from an amplification chain (3) of a transmitter including at its input a variable attenuator (2) controlled as a function of the level of the output signal from the amplification chain (3), characterized in that it comprises a summator circuit (4) for controlling the attenuation of the attenuator circuit (2), the summator circuit (4) being coupled by a first input, to the output of the amplification chain (3) by way of a detection circuit (5) and by a second input to the output of a control circuit (6) by way of a shaping stage (7), the control circuit (6) being controlled by the level of the signal applied to the input of the attenuator (2) so as to adjust the gain of the amplification chain to its minimum value in the absence of any input signal and to release the gain progressively as soon as the input signal appears.

2. Device according to Claim 1, characterized in that the summator circuit (4) delivers a voltage for controlling the attenuator (2) which is the weighted sum of the voltages delivered by the detection circuit (5) and the shaping circuit (7), the weighting applied to the voltage delivered by the shaping circuit (7) being K times greater than that delivered by the detection circuit (5).

3. Device according to Claim 2, characterized in that the shaping circuit (7) comprises a capacitor discharge circuit (11) for regulating the rise in the low-frequency signal attenuated by the attenuator (2).

4. Device according to Claim 3, characterized in that the control circuit (6) comprises a comparator circuit (14), coupled to a monostable circuit (16) so as to deliver a control signal to the shaping circuit (7) when the signal applied to the input of the attenuator (2) exceeds a predetermined threshold value.

FIG.1

FIG.2

FIG.3

FIG.4